# EUROPEAN PATENT APPLICATION

(11) **EP 2 426 720 A1**
(43) Date of publication of application: **07.03.2012**
(21) Application number: 10175294.7
(22) Date of filing: 03.09.2010
(51) Int. Cl.: H01L 29/45, H01L 29/49, H01L 29/786, H01L 23/532

(54) **Staggered thin film transistor and method of forming the same**

(71) Applicant: Applied Materials, Inc., Santa Clara, CA 95054 (US)
(72) Inventor: Pieralisi, Fabio, 63739, Aschaffenburg (DE)
(74) Representative: Zimmermann & Partner

(57) **Abstract**

A staggered thin film transistor and a method of forming the staggered thin film transistor are provided. The thin film transistor includes an annealed layer stack including an oxide containing layer, a copper alloy layer deposited on the conductive oxide layer, a copper containing oxide layer, and a copper containing layer.

## Description

### FIELD OF THE INVENTION

The present invention relates to a thin film transistor and a method of forming a thin film transistor. Specifically, it relates to a staggered, in particular an inverted staggered thin film transistor, e.g., an inverted staggered transparent oxide thin film transistor, and manufacturing methods thereof.

### BACKGROUND OF THE INVENTION

Thin film transistors (TFTs) play an important role in liquid crystal display applications and other industries. In conventional inverted staggered transparent oxide TFTs, source and drain electrodes are directly deposited on the active channel island.

However, the device performance may suffer from the contact resistance between the source and the active channel or between the drain and the active channel.

Consequently, it is desirable to develop an improved thin film transistor.

### SUMMARY

In light of the above, according to embodiments described herein, a staggered thin film transistor is provided. The thin film transistor includes an annealed layer stack including an oxide containing layer, a copper alloy layer deposited on the oxide containing layer, a copper containing oxide layer, and a copper containing layer.

According to further embodiments, a method of forming a staggered thin film transistor is provided. The method includes providing an oxide containing layer of the thin film transistor, depositing a copper alloy layer on the oxide containing layer, depositing a copper containing oxide layer on the copper alloy layer, and depositing a copper containing layer on the copper containing oxide layer. The method further includes annealing the oxide containing layer, the copper alloy layer, the copper containing oxide layer and the copper containing layer.

Embodiments are also directed to methods of using and operating the staggered thin film transistor. These method steps may be performed manually or automated, e.g. controlled by a computer programmed by appropriate software, by any combination of the two or in any other manner.

Further advantages, features, aspects and details that can be combined with embodiments described herein are evident from the dependent claims, the description and the drawings.

### BRIEF DESCRIPTION OF THE DRAWINGS

So that the manner in which the above recited features of the present invention can be understood in detail, a more particular description of the invention, briefly summarized above, may be had by reference to embodiments. The accompanying drawings relate to embodiments of the invention and are described in the following:
Fig. 1 shows an inverted staggered thin film transistor structure;
Figs. 2 and 3 show an annealed layer stack according to embodiments described herein;
Fig. 4 illustrates a method of manufacturing a thin film transistor according to embodiments described herein.

### DETAILED DESCRIPTION OF THE INVENTION

Reference will now be made in detail to the various embodiments of the invention, one or more examples of which are illustrated in the figures. Each example is provided by way of explanation of the invention and is not meant as a limitation of the invention. For example, features illustrated or described as part of one embodiment can be used on or in conjunction with other embodiments to yield yet a further embodiment. It is intended that the present invention includes such modifications and variations.

The expression "staggered TFT" shall include both bottom-gate and top-gate versions of a TFT while "inverted staggered TFT" shall refer to a bottom-gate TFT. In the following, an inverted staggered structure will be described. Embodiments of the invention are applicable to staggered and other TFT structures, such as coplanar TFTs. A layer of the TFT is a region of the TFT consisting of material(s). Therein at least one physical or chemical property of a layer is different as compared to an adjacent layer of the TFT.

Within the following description of the drawings, the same reference numbers refer to the same components. Only the differences with respect to the individual embodiments are described. The drawings are not necessarily true to scale and features may be exaggerated for illustration.

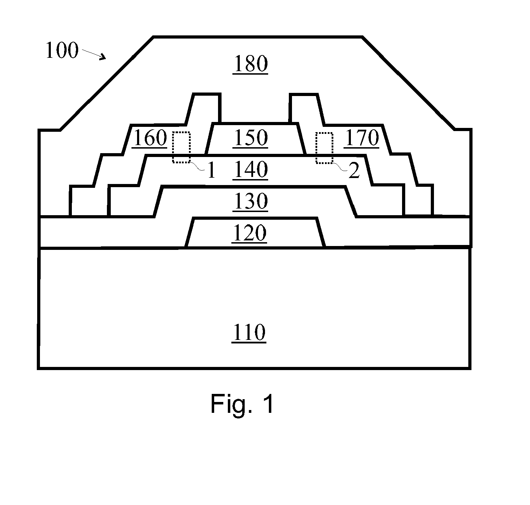

Fig. 1 shows the structure of an inverted staggered thin film transistor 100. The TFT 100 includes a substrate 110. The substrate may be a glass substrate. Alternatively, the substrate may be plastic substrate, ceramic substrate or metal substrate, possibly provided with an insulating film such silicon oxide. The substrate may include at least one material chosen from silicon oxide, barium borosilicate glass, aluminoborosilicate glass, aluminosilicate glass, and combinations thereof.

A gate 120 is formed on the substrate 110. The gate 120 may include at least one material chosen from copper, titanium, molybdenum, chromium, tantalum, tungsten, aluminum, silver, gold, ITO, an alloy material thereof, e.g., an aluminum-neodymium alloy or an aluminum-selenium alloy, and combinations thereof. The gate may be deposited on the substrate, e.g., by sputtering, such as magnetron sputtering. The TFT 100 includes a gate dielectric 130 formed on the gate 120 and the substrate 110. The gate dielectric may include at least one material chosen from silicon oxide, silicon nitride, silicon oxynitride, aluminum oxide, titanium oxide, and combinations thereof.

Further, TFT 100 includes an active channel region 140, e.g., an active channel island including a transparent oxide. The active channel region 140 is formed on the gate dielectric 130. The active channel region may include at least one material chosen from transparent oxide, zinc oxide, zinc tin oxide, zinc indium tin oxide, indium zinc oxide, indium gallium zinc oxide, hafnium indium zinc oxide, aluminum zinc tin oxide, copper oxide, and combinations thereof. An etch stop layer 150 may be formed on the active channel 140. The etch stop layer may include at least one material chosen from silicon oxide, silicon nitride, silicon oxynitride, aluminum oxide, titanium oxide, and combinations thereof.

A source 160 and a drain 170 are formed on the active channel 140. The source and drain may include at least one material chosen from copper, titanium, molybdenum, chromium, tantalum, tungsten, aluminum, silver, gold, ITO, alloys thereof, and combinations thereof. The etch stop layer 150 can be between the source 160 and the drain 170. Further, a passivation layer 180 may be formed on the whole structure, also separating the source 160 and the drain 170. The passivation layer may include at least one material chosen from silicon oxide, silicon nitride, silicon oxynitride, aluminum oxide, titanium oxide, and combinations thereof.

A contact resistance may exist between the source 160 and the active channel region 140 and/or between the drain 170 and the active channel region 140. For instance, if the metallization of the electrodes 160, 170 is copper-based, e.g., for connection to copper wires, and the active channel is made of a transparent oxide such as zinc oxide, a contact resistance exists. The contact resistance may decrease the performance of the TFT.

According to embodiments described herein, a thin film transistor is provided. The thin film transistor may be an inverted staggered TFT. The thin film transistor includes an annealed layer stack. The annealed layer stack includes a conductive oxide layer, a copper alloy layer, a copper containing oxide layer, and a copper containing layer. The conductive oxide layer may be the active channel region.

The copper alloy layer, copper containing oxide layer and copper containing layer may be sub-layers of the source or the drain electrode. The copper alloy layer may be deposited on the conductive oxide layer. The copper containing oxide layer may alternatively be absent. If it is present, it may be deposited on the copper alloy layer. The copper containing layer may be deposited on the copper containing oxide layer, or on the copper alloy layer if the copper containing oxide layer is not present.

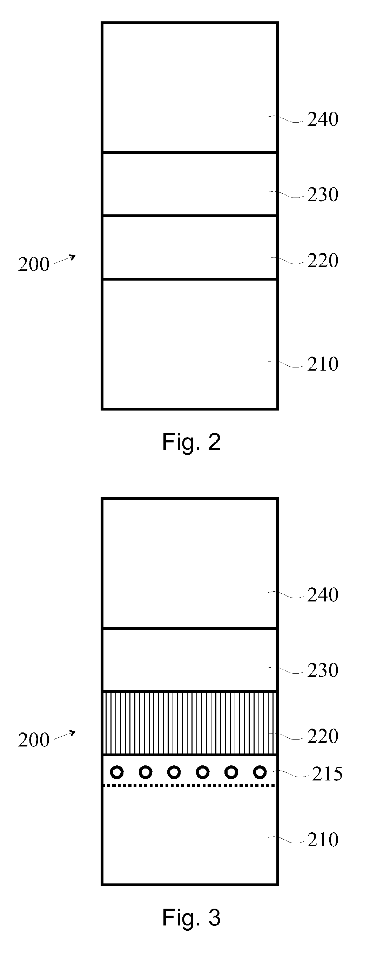

Fig. 2 shows a layer stack 200 of this type. The layer stack 200 includes conductive oxide layer 210, which may, e.g., be identical with the active channel 140. The layer stack 200 further includes copper alloy layer 220, copper containing oxide layer 230, and copper containing layer 240. Layers 220, 230, 240 may, e.g., be sub-layers of source electrode 160 or drain electrode 170.

The layer stack 200 shown in Fig. 2 may, e.g., be part of the TFT structure shown in Fig. 1, and may correspond to the regions 1 or 2 represented by dashed boxes in Fig. 1. The TFT structure may include more than one layer stack according to embodiments described herein, e.g., at least two separate layer stacks as represented by the dashed boxes 1 and 2 in Fig. 1, and corresponding to a source/active channel layer stack and a drain/active channel layer stack.

In Fig. 2, the copper alloy layer 220 is formed on, and contacts, the conductive oxide layer 210. The copper containing oxide layer 230 is formed on, and contacts, the copper alloy layer 220. The copper containing layer 240 is formed on, and contacts, the copper containing oxide layer 230.

The conductive oxide layer may be a transparent oxide layer, particularly a ZnO-containing layer, a ZTO-containing layer, a ZITO-containing layer, an IZO-containing layer, an IGZO-containing layer, a HIZO-containing layer, an AZTO-containing layer, a Cu₂O-containing layer, and combinations thereof. The conductive oxide layer may be formed on a gate dielectric, e.g., as shown in Fig. 1.

The copper alloy layer may be formed on the conductive oxide layer, e.g., after formation of an etch stop layer. The copper alloy layer may be formed by depositing a first buffer film, e.g., by sputtering a Cu alloy, wherein the alloying material may be Mn, Mg, Cr, Mo, Ca and combinations thereof. Sputtering may be magnetron sputtering, e.g. static magnetron sputtering, reactive magnetron sputtering or static reactive magnetron sputtering. The copper target may, e.g., be Cu4N.

At least the conductive oxide layer and the first buffer film may be annealed. By annealing at least the conductive oxide layer and the first buffer film, the first buffer film is at least partly oxidized. In particular, the alloying element may be oxidized. Therein, the oxygen contained in the conductive oxide layer may oxidize the alloying element. This process will be called copper alloy self-forming barrier process.

The copper alloy layer may include at least one material selected from the group consisting of: an alloy material that is at least partly oxidized, Cu, Mn, Mg, Cr, Mo, Ca, oxides of Cu, Mn, Mg, Cr, Mo, Ca, and combinations thereof. The copper alloy layer may be a sputtered, annealed copper alloy layer. Annealing may be vacuum annealing. The copper alloy layer may be an oxidized or partly oxidized copper alloy layer, e.g., a partly oxidized copper alloy layer in which the alloying material(s) is/are oxidized. The copper alloy layer may include at least 80% by weight copper, or at least 90 % by weight copper, or at least 95 % by weight copper, or even at least 99.5 % by weight copper. The copper alloy layer may, e.g., include at most 20% by weight of material other than copper, or at most 10 % by weight of material other than copper, e.g., alloying material, or at most 5 % by weight, or even at most 0.5 % by weight.

The annealing may be carried out, e.g., after forming the whole layer stack according to embodiments described herein, or after forming at least some further layers. An "annealed layer stack" shall refer to a layer stack, at least one layer of which besides the copper alloy layer is annealed, more specifically at least one layer besides the first buffer layer.

According to some embodiments, the copper containing oxide layer is formed on the first buffer film, respectively on the conductive oxide layer. The copper containing oxide layer may be a second buffer film. It may be deposited, for instance by sputtering such as reactive magnetron sputtering. For example, substantially pure copper such as Cu4N may be sputtered in a gas atmosphere including argon and oxygen. The copper containing oxide layer may include at least one material chosen from: CuO, Cu₂O, and combinations thereof. The copper containing oxide layer may include at least 79 % by weight copper, or at least 90 % by weight copper, or even at least 99.9 % by weight copper. The copper containing oxide layer may, e.g., include at most 20 % by weight of material other than copper, e.g., oxygen, or at most 10 % by weight, or even at most 0.1 % by weight.

When annealing the layer stack, oxygen from the copper containing oxide layer may oxidize the copper alloy layer. This process may occur additionally or alternatively to the oxidization by oxygen from the conductive oxide layer. At least one layer chosen from the conductive oxide layer and the copper containing oxide layer may have an oxygen depletion zone adjacent to the copper alloy layer. In particular, the oxygen depletion zone may be due to the Cu alloy self-forming barrier process at the interface with the conductive oxide layer and/or the copper containing oxide layer. The thickness of the Cu alloy layer may such that the Cu alloy layer is completely oxidized after the self-forming barrier process. The thickness may be very thin to achieve this.

The copper containing layer may be formed on the copper containing oxide layer, e.g., by sputtering. In particular, sputtering may be carried out by sputtering directly on the copper containing oxide layer, e.g., in pure argon atmosphere. The same sputter target, e.g., a rotary sputter target, may be used as in the case of sputtering the copper containing oxide layer. The sputter target may be used without sputter cleaning between formation of the copper containing oxide layer and the copper containing layer. For instance, Cu4N may be used as sputter target. The copper containing layer may include at least 90 % by weight copper, or at least 95 % by weight copper, or even at least 99.99 % by weight copper. The copper containing oxide layer may, e.g., include at most 10 % by weight of material other than copper, or at most 5 % by weight, or even at most 0.01 % by weight. The copper containing layer may substantially consist of copper. Therein, "substantially consisting of copper" means consisting of copper apart from impurities.

It may be sufficient to stop oxygen supply to the sputtering gas atmosphere. The formation process is thereby simplified. The copper containing layer may be thicker than the copper containing oxide layer and/or the copper alloy layer. It may form the main portion of a source or drain electrode, or a terminal for circuitry such as copper wires.

Fig. 3 shows an annealed layer stack 200 including the conductive oxide layer 210. The conductive oxide layer 210 includes an oxygen depletion zone 215 adjacent to the contact region with the copper alloy layer 220. The oxygen depletion is schematically illustrated by open circles in the zone 215, and the at least partial oxidization of copper alloy layer 220 is indicated by a pattern of vertical lines. The copper containing oxide layer 230 may also include an oxygen depletion zone adjacent to the copper alloy layer. The layer stack 200 shown in Fig. 3 is annealed after formation of its layers 210-240.

The layers may have thicknesses in the following ranges according to some embodiments. The conductive oxide layer may have a thickness from 20 nm to 150 nm. The copper alloy layer may have a thickness from 2 nm to 30 nm. The copper containing oxide layer may have a thickness from 2 nm to 50 nm, e.g. from 2 nm to 30 nm. The copper containing layer may have a thickness from 50 nm to 500 nm, e.g., from 100 nm to 400 nm. The thickness of an oxygen depletion zone may be in the range from 0.1 nm to 3 nm.

The contact resistance depends on the material characteristics of contacting layers. For instance, the conductivity of the conductive oxide layer, e.g., a transparent oxide layer such as ZnO, depends on the concentration of oxygen vacancies in the material. The conductivity may be proportional to the concentration of vacancies. By creating an oxygen-deficient layer (oxygen depletion zone) in the conductive oxide layer at the contact region to the copper alloy layer, its conductivity can be controlled through the Cu alloy self-forming barrier process. The conductivity at the borders of other layers may be controlled alternatively or additionally. In this way, the contact resistance can be reduced and the performance of the TFT be increased.

In particular, the oxygen content of the conductive oxide layer and/or the copper containing oxide layer may be adapted such that the desired oxidization of the copper alloy layer is achieved. The properties of the copper alloy layer, in particular of the alloying element or the alloying elements may be adapted such that the desired oxidization of the copper alloy is achieved. The oxygen donation or reception properties of the layers may be adapted such that the desired concentration of oxygen vacancies in oxygen depletion zones of the respective layers is achieved.

Further control is provided by controlling the deposition parameters of the layers and the annealing parameters. For instance, the power at the sputtering cathodes, the pressure of the sputtering gas or the partial pressures of the sputtering gases, the composition of the sputtering gases such as the argon/oxygen mixture, and the deposition time may be varied. Additionally or alternatively, the annealing time and/or the annealing temperature may be controlled. In this way, the extent of the reduction of the contact resistance and the properties of the adhesion/barrier layer may be controlled and adapted to the process requirements for TFT production.

The resistivity properties between any pair of layers of the layer stack may be matched such that the contact resistance is low. This will be referred to as matching of the contact resistance or RC-matching. Specifically, the contact resistance may be matched by annealing. The contact resistance, or actually values (R_{C}.W), between RC-matched layers may, e.g., be from 1 to 10000 **Ω**cm. In particular, the conductive oxide layer and the copper alloy layer may be RC-matched.

Optionally, an oxygen depletion zone of the conductive oxide layer provides RC-matching to the copper alloy layer. The oxidization of the copper alloy layer by oxygen from the oxygen depletion zone of the conductive oxide layer may further contribute to RC-matching. In some embodiments, the copper alloy layer and the copper containing oxide layer are RC-matched. Here, an oxygen depletion zone of the copper containing oxide layer may provide RC-matching to the copper alloy layer. The oxidization of the copper alloy layer by oxygen from the oxygen depletion zone of the copper containing oxide layer may further contribute to RC-matching.

Any of the oxygen depletion zones may be adapted to match the resistivity properties of the corresponding adjacent layers, i.e., it may be adapted for RC-matching. The annealed layer stack may be an annealed RC-matched layer stack. Therein, the layer stack is referred to as RC-matched if at least one layer pair chosen from the pair conductive oxide layer/copper alloy layer and from the pair copper alloy layer/copper containing oxide layer is RC-matched.

According to further embodiments, a method of forming a staggered thin film transistor is provided. The method includes providing a conductive oxide layer of the thin film transistor, depositing a copper alloy layer on the conductive oxide layer, depositing a copper containing oxide layer on the copper alloy layer, and depositing a copper containing layer on the copper containing oxide layer. The method further includes annealing the copper alloy layer and at least one of the layers chosen from the conductive oxide layer, the copper containing oxide layer, and the copper containing layer. Annealing may include annealing the conductive oxide layer, the copper alloy layer, the copper containing oxide layer and the copper containing layer.

Annealing may include oxidizing at least one alloy material of the copper alloy layer with oxygen from at least one layer chosen from: the conductive oxide layer and the copper containing oxide layer. The copper alloy layer, in particular the alloying element or the alloying elements of the copper alloy layer, may be exclusively oxidized with oxygen from the conductive oxide layer and/or the copper containing oxide layer. Annealing may include forming at least one oxygen depletion zone in the conductive oxide layer and/or the copper containing oxide layer. Therein, the oxygen depletion zone may be adapted for RC-matching the conductive oxide layer and the copper alloy layer and/or for RC-matching the copper alloy layer and the copper containing oxide layer. Annealing may include forming an RC-matched layer stack, wherein the RC-matched layer stack may be any layer stack according to embodiments described herein.

Depositing of the copper alloy layer may include sputtering of a copper alloy. Sputtering may be magnetron sputtering, such as static and/or reactive magnetron sputtering of the copper alloy. Therein, the copper alloy may, e.g., be chosen from: Mn, Mg, Cr or mixtures thereof.

Depositing of the copper containing oxide layer may include sputtering of copper in an oxygen-containing gas environment. The gas environment may include Ar and **O**₂. Sputtering may include magnetron sputtering of copper, e.g., reactive magnetron sputtering, such as reactive magnetron with rotary targets.

Depositing of the copper containing layer may include sputtering of copper in an inert gas environment. In some embodiments, the inert gas environment includes Ar. Sputtering my include magnetron sputtering of copper, e.g., reactive magnetron sputtering, such as reactive magnetron with rotary targets. Therein, sputtering of the copper containing layer may include sputtering with the same targets as in the sputtering of the copper containing oxide layer. The targets may be untreated (in particular not cleaned) between sputtering the copper containing oxide layer and sputtering the copper containing layer.

The copper alloy layer, the copper containing oxide layer, and the copper containing layer may form an electrode of the thin film transistor in contact with the conductive oxide layer forming the active channel region of the thin film transistor. However, embodiments of the present invention are not limited thereto. The self-formation of a barrier layer and/or of at least one oxygen depletion zone may be applied to other layers of the TFT structure as well.

According to a further embodiment, which can be combined with any of the embodiments described herein, a method of forming a gate metallization is provided. The method includes depositing a gate electrode metallization on a substrate of a thin film transistor. The thin film transistor may be a thin film transistor according to embodiments described herein, in particular a staggered/ inverted staggered TFT with a layer stack as described herein.

The method of forming a gate metallization may further include annealing the gate electrode metallization to at least partly oxidize the gate electrode metallization by oxygen from the substrate. The annealing of the gate electrode metallization may be identical with the annealing of the layer stack, or it may be a separate annealing.

The annealed layer stack according to the embodiments described above can also be at the interface between the substrate and the gate electrode of the thin film transistor. In this case, the conductive oxide layer is replaced by the substrate. The substrate may be made of the substrate materials described in the foregoing, and contains oxygen. In particular, the substrate may contain oxygen in the form of an oxide such as silicon oxide. The copper alloy layer may then be oxidized by the oxygen from the substrate and/or from the copper containing oxide layer. RC-matching occurs only between the copper alloy layer, the copper containing oxide layer and the copper containing layer. These three layers form, or form a part of, the gate electrode. The gate electrode may be a multi-layer electrode.

Figs. 2 and 3 also illustrate these embodiments, wherein the layer with reference sign 210 is now the substrate or an oxygen-containing coating of the substrate, e.g., the substrate 110 of Fig. 1. The copper alloy layer 220, the copper containing oxide layer 230, and the copper containing layer 240 may, e.g., be included in the gate electrode 120 of Fig. 1.

According to further embodiments, the annealed layer stack includes an oxygen containing layer, in particular an oxide containing layer. The oxide containing layer may be the conductive oxide layer as described above. The oxide containing layer may be the substrate or a part thereof, such as a coating of the substrate. The annealed layer stack includes the copper alloy layer, the copper containing oxide layer and the copper containing layer, which may have the properties described above. If the oxide containing layer is the conductive oxide layer, these three layers may be part of the source and/or drain electrode of the thin film transistor. If the oxide containing layer is the substrate or a part thereof, these three layers may form, or be part of, the gate electrode.

According to further embodiments, the thin film transistor may include at least two annealed layer stacks according to the embodiments described herein. In particular, the thin film transistor may include a first annealed layer stack at the interface of the substrate and the gate electrode, and a second annealed layer stack at the interface of the active channel and the source/drain electrode(s). Further, the method of forming the first and second annealed layer stacks may be substantially the same (the oxide containing layer being the substrate in the first annealed layer stack and being the conductive oxide layer of the active channel in the second annealed layer stack).

The fact that the annealed layer stacks and the methods of forming the same can be adopted both for drain/source electrodes and gate electrodes constitutes an advantage. In this way, the complexity of the production process can be reduced. For instance, the same apparatuses can be used for the formation of these parts of the thin film transistors. Production costs as well as costs of the equipment of the production site may be lowered, and throughput be increased.

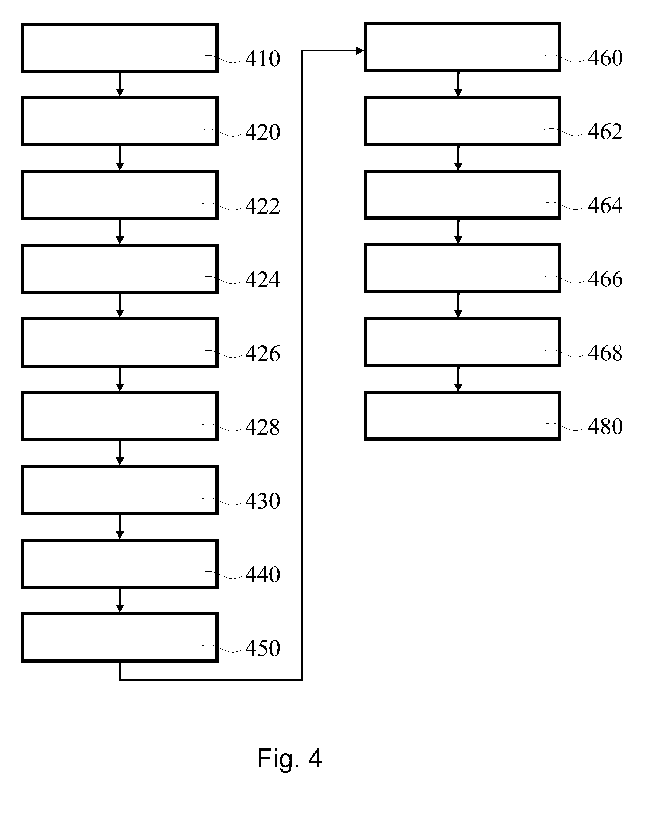

Fig. 4 schematically illustrates a method of forming a thin film transistor. The method includes providing 410 a substrate and forming 420 a gate electrode on the substrate. Forming the gate electrode may include depositing 422 a copper alloy layer on the substrate, depositing 424 a copper containing oxide layer on the copper alloy layer, and depositing 426 a copper containing layer on the copper containing oxide layer. The method may include annealing 428 the substrate, the copper alloy layer, the copper containing oxide layer and the copper containing layer.

The method may further include forming 430 a gate dielectric on the substrate and the gate electrode, and forming 440 an active channel region on the gate dielectric. Therein, the gate dielectric is formed such that it provides an electrical insulation between the gate electrode and the active channel region. The active channel region includes, or consists of, a conductive oxide layer. The method may include forming 450 an etch stop layer on the active channel region.

The method may further include forming 460 a source electrode and forming a drain electrode on the conductive oxide layer of the active channel region. The formation of source and drain electrode may include forming an electrode layer and separating the electrode layer into a source electrode and a drain electrode by etching, such as etching to the etch stop layer. Forming the source electrode and the drain electrode, respectively forming the electrode layer, may include depositing 462 a second copper alloy layer on the conductive oxide layer, depositing 464 a second copper containing oxide layer on the second copper alloy layer, and depositing 466 a second copper containing layer on the second copper containing oxide layer. The method may include annealing 468 the conductive oxide layer, the second copper alloy layer, the second copper containing oxide layer and the second copper containing layer.

The method may include forming 480 a passivation layer on the source electrode, the drain electrode, and/or on the etch stop layer, separating the source and the drain electrode.

The method includes either formation steps 420-426 of the gate electrode or formation steps 460-466 of the drain/source electrodes, or includes both the formation steps 420-426 and 460-466. The method includes at least one annealing step, e.g., step 428 or step 468 or both.

While the foregoing is directed to embodiments of the invention, other and further embodiments of the invention may be devised without departing from the basic scope thereof, and the scope thereof is determined by the claims that follow.

## Claims

1. A staggered thin film transistor, comprising:
an annealed layer stack (200) comprising:
an oxide containing layer (210);
a copper alloy layer (220) deposited on the oxide containing layer;
a copper containing oxide layer (230); and
a copper containing layer (240).

2. The staggered thin film transistor according to claim 1, wherein the staggered thin film transistor is an inverted staggered thin film transistor.

3. The staggered thin film transistor according to claim 1 or 2, wherein the oxide containing layer is a conductive oxide layer.

4. The staggered thin film transistor according to claim 3, wherein the conductive oxide layer is a transparent oxide layer, particularly a ZnO-containing or IGZO-containing layer.

5. The staggered thin film transistor according to any of the preceding claims, wherein at least one layer chosen from the oxide containing layer and the copper containing oxide layer has an oxygen depletion zone (215) adjacent to the copper alloy layer.

6. The staggered thin film transistor according to any of the preceding claims, wherein the copper alloy layer includes at least one material selected from the group consisting of: an alloy material that is at least partly oxidized, Cu, Mn, Mg, Cr, Mo, Ca, oxides of Cu, Mn, Mg, Cr, Mo, Ca, and combinations thereof.

7. The staggered thin film transistor according to any of the preceding claims, wherein the copper alloy layer, the copper containing oxide layer, and the copper containing layer form an electrode of the thin film transistor in contact with the oxide containing layer, which forms the active channel region of the thin film transistor.

8. The staggered thin film transistor according to claims 1, 2, 5 or 6, wherein the copper alloy layer, the copper containing oxide layer, and the copper containing layer form a gate electrode of the thin film transistor in contact with the oxide containing layer, which forms at least part of the substrate of the thin film transistor.

9. A method of forming a staggered thin film transistor, comprising:
providing an oxide containing layer (210) of the thin film transistor;
depositing a copper alloy layer (220) on the oxide containing layer;
depositing a copper containing oxide layer (230) on the copper alloy layer;
depositing a copper containing layer (240) on the copper containing oxide layer; and
annealing the oxide containing layer, the copper alloy layer, the copper containing oxide layer and the copper containing layer.

10. The method according to claim 9, wherein annealing comprises oxidizing at least one alloy material of the copper alloy layer with oxygen from at least one layer chosen from: the oxide containing layer and the copper containing oxide layer.

11. The method according to any of the claims 9 to 10, wherein depositing of the copper alloy layer includes sputtering of a copper alloy, optionally magnetron sputtering of the copper alloy, wherein the alloying material of the copper alloy is optionally chosen from: Mn, Mg, Cr, Mo, Ca or mixtures thereof.

12. The method according to any of the claims 9 to 11, wherein depositing of the copper containing oxide layer includes sputtering of copper, optionally magnetron sputtering of copper, in an oxygen containing gas environment, optionally in a gas environment that includes Ar and O₂.

13. The method according to any of the claims 9 to 12, wherein depositing of the copper containing layer includes sputtering of copper, optionally magnetron sputtering of copper, in an inert gas environment, optionally in an inert gas environment that includes Ar.

14. The method according to any of the claims 9 to 13, wherein the oxide containing layer is a conductive oxide layer, and wherein the copper alloy layer, the copper containing oxide layer, and the copper containing layer form an electrode of the thin film transistor in contact with the conductive oxide layer, which forms the active channel region of the thin film transistor.

15. The method according to any of claims 9 to 14, further comprising:
depositing a gate electrode metallization on a substrate of the staggered thin film transistor; and
annealing the gate electrode metallization to at least partly oxidize the gate electrode metallization by oxygen from the substrate.

## Amended claims

### Amended claims in accordance with Rule 137(2) EPC.

**1.** A staggered thin film transistor, comprising:
an annealed layer stack (200) comprising:
an oxide containing layer (210);
a copper alloy layer (220) deposited on the oxide containing layer;
a copper containing oxide layer (230) formed on the copper alloy layer; and
a copper containing layer (240) formed on the copper containing oxide layer.

**2.** The staggered thin film transistor according to claim 1, wherein the staggered thin film transistor is an inverted staggered thin film transistor.

**3.** The staggered thin film transistor according to claim 1 or 2, wherein the oxide containing layer is a conductive oxide layer.

**4.** The staggered thin film transistor according to claim 3, wherein the conductive oxide layer is a transparent oxide layer, particularly a ZnO-containing or IGZO-containing layer.

**5.** The staggered thin film transistor according to any of the preceding claims, wherein the copper alloy layer, the copper containing oxide layer, and the copper containing layer form an electrode of the thin film transistor in contact with the oxide containing layer, which forms the active channel region of the thin film transistor.

**6.** The staggered thin film transistor according to claims 1 or 2, wherein the copper alloy layer, the copper containing oxide layer, and the copper containing layer form a gate electrode of the thin film transistor in contact with the oxide containing layer, which forms at least part of the substrate of the thin film transistor.

**7.** The staggered thin film transistor according to any of the preceding claims, wherein at least one layer chosen from the oxide containing layer and the copper containing oxide layer has an oxygen depletion zone (215) adjacent to the copper alloy layer.

**8.** The staggered thin film transistor according to any of the preceding claims, wherein the copper alloy layer includes at least one material selected from the group consisting of: an alloy material that is at least partly oxidized, Cu, Mn, Mg, Cr, Mo, Ca, oxides of Cu, Mn, Mg, Cr, Mo, Ca, and combinations thereof.

**9.** A method of forming a staggered thin film transistor, comprising:
providing an oxide containing layer (210) of the thin film transistor;
depositing a copper alloy layer (220) on the oxide containing layer;
depositing a copper containing oxide layer (230) on the copper alloy layer;
depositing a copper containing layer (240) on the copper containing oxide layer; and
annealing the oxide containing layer, the copper alloy layer, the copper containing oxide layer and the copper containing layer.

**10.** The method according to claim 9, wherein annealing comprises oxidizing at least one alloy material of the copper alloy layer with oxygen from at least one layer chosen from: the oxide containing layer and the copper containing oxide layer.

**11.** The method according to any of the claims 9 to 10, wherein depositing of the copper alloy layer includes sputtering of a copper alloy, optionally magnetron sputtering of the copper alloy, wherein the alloying material of the copper alloy is optionally chosen from: Mn, Mg, Cr, Mo, Ca or mixtures thereof.

**12.** The method according to any of the claims 9 to 11, wherein depositing of the copper containing oxide layer includes sputtering of copper, optionally magnetron sputtering of copper, in an oxygen containing gas environment, optionally in a gas environment that includes Ar and O₂.

**13.** The method according to any of the claims 9 to 12, wherein depositing of the copper containing layer includes sputtering of copper, optionally magnetron sputtering of copper, in an inert gas environment, optionally in an inert gas environment that includes Ar.

**14.** The method according to any of the claims 9 to 13, wherein the oxide containing layer is a conductive oxide layer, and wherein the copper alloy layer, the copper containing oxide layer, and the copper containing layer form an electrode of the thin film transistor in contact with the conductive oxide layer, which forms the active channel region of the thin film transistor.

**15.** The method according to any of claims 9 to 14, further comprising:
depositing a gate electrode metallization on a substrate of the staggered thin film transistor; and
annealing the gate electrode metallization to at least partly oxidize the gate electrode metallization by oxygen from the substrate.
